# EUROPEAN PATENT SPECIFICATION

(11) **EP 3 699 319 B1**
(45) Date of publication and mention of the grant of the patent: **04.12.2024**
(21) Application number: 18868418.7
(22) Date of filing: 04.10.2018
(51) Int. Cl.: C23C 14/56, C23C 16/54, C23C 14/20, C23C 14/50, C23C 14/54

(54) **CAN ROLL AND LONG SUBSTRATE TREATMENT DEVICE**
WALZE UND VORRICHTUNG ZUR BEHANDLUNG VON LANGEN SUBSTRATEN
ROULEAU SCELLÉ ET DISPOSITIF DE TRAITEMENT DE SUBSTRAT LONG

(30) Priority: 17.10.2017 JP 2017201081
(43) Date of publication of application: 26.08.2020
(73) Proprietor: Sumitomo Metal Mining Co., Ltd., Tokyo 105-8716 (JP)
(72) Inventor: OKAMI, Hideharu, Niihama-shi Ehime 792-0008 (JP)
(74) Representative: TBK
(86) International application number: PCT/JP2018/037167
(87) International publication number: WO 2019/078015

(56) References cited:
- WO-A1-2018/038141
- JP-A- 2012 132 081
- JP-A- 2016 079 494
- JP-A- 2017 043 822
- JP-A- 2017 137 543

## Description

### TECHNICAL FIELD

The present invention relates to a long substrate treatment apparatus for performing a surface treatment that applies a thermal load such as ion beam treatment or sputtering deposition on a long substrate such as a long heat-resistant resin film transferred through a vacuum chamber in a roll-to-roll manner and wrapped on the outer peripheral surface of a can roll, and relates in particular to an improvement in a can roll including a gas discharge mechanism with high cooling performance and being capable of suppressing gas leakage from the outer peripheral surface of the can roll on which a long substrate cannot be wrapped, and a long substrate treatment apparatus using this can roll.

### BACKGROUND ART

Flexible wiring substrates are used in liquid crystal panels, laptop computers, digital cameras, mobile phones, and so on. A flexible wiring substrate is fabricated from a metal film-coated heat-resistant resin film obtained by depositing a metal film on one or both surfaces of heat-resistant resin film. In recent years, wiring patterns formed on flexible wiring substrates have increasingly become finer and denser and it has become more important for metal film-coated heat-resistant resin films themselves to be flat and smooth with no wrinkles or the like.

Conventional methods of manufacturing this type of metal film-coated heat-resistant resin film have known such as: a manufacturing method in which a metal foil is attached to a heat-resistant resin film with an adhesive (referred to as the three-layer substrate manufacturing method); a manufacturing method in which a metal foil is coated with a heat-resistant resin solution and then the resin solution is dried (referred to as the casting method); and a manufacturing method in which a metal film is deposited on a heat-resistant resin film by a dry plating method (vacuum deposition method) or a combination of a dry plating method (vacuum deposition method) and a wet plating method (referred to as the metallizing method). Also, the dry plating method (vacuum deposition method) in the metallizing method includes vacuum vapor deposition methods, sputtering methods, ion plating methods, ion beam sputtering methods, and so on.

As the metallizing method, JP H02 98994 A discloses a method in which chromium is sputtered onto a polyimide insulating layer and then copper is sputtered to form a conductive layer on the polyimide insulating layer. Also, JP 3 447 070 B2 discloses a flexible circuit board material formed by sequentially laminating a first metal thin film formed by sputtering a target of a copper-nickel alloy and a second metal thin film formed by sputtering a target of copper onto a polyimide film. Note that a sputtering web coater is usually used to perform vacuum deposition on a heat-resistant resin film (substrate) such as a polyimide film.

Generally, among the vacuum deposition methods mentioned above, the sputtering methods have been said to provide better bond but apply a larger thermal load to the heat-resistant resin film than the vacuum vapor deposition methods. Moreover, it has also been known that applying a large thermal load to the heat-resistant resin film during the deposition makes the film more prone to formation of wrinkles. To prevent the formation of the wrinkles, sputtering web coaters as apparatuses for manufacturing a metal film-coated heat-resistant resin film are equipped with a can roll having a cooling function, and employ an method in which this can roll is rotationally driven while a heat-resistant resin film transferred in a roll-to-roll manner is wrapped on a transfer path defined on the outer peripheral surface of the can roll, to thereby cool the heat-resistant resin film from its back surface during the sputtering process.

For example, JP S62 247073 A discloses an unwinding-winding type (roll-to-roll type) vacuum sputtering apparatus as an example of the sputtering web coaters. This unwinding-winding type vacuum sputtering apparatus includes a cooling roll that serves as the above can roll, and performs control that brings a film into tight contact with the cooling roll by using an additional sub roll provided at least on the film infeed side or the film outfeed side of the cooling roll.

However, as described in "Vacuum Heat Transfer Models for Web Substrates: Review of Theory and Experimental Heat Transfer Data", 2000 Society of Vacuum Coaters, 43rd Annual Technical Conference Proceeding, Denver, April 15-20, 2000, p.335, the outer peripheral surface of the can roll is not flat when viewed microscopically. Thus, between the can roll and the film transferred in tight contact with its outer peripheral surface, gap regions (clearances) are present which separate them with a vacuum space therebetween. Accordingly, it cannot be said that the heat in the film generated during sputtering or vapor deposition is actually efficiently transferred to the can roll from the film. This has been a cause of the formation of film wrinkles.

To solve this, a technique has been proposed in which a gas is introduced into the gap regions between the outer peripheral surface of the can roll and the film from the can roll side to thereby make the thermal conductivity of the gap regions higher than the vacuum.

Further, as specific methods of introducing a gas into the gap regions from the can roll side, for example WO 2005/001157 A2 discloses a technique in which many small holes are provided in the outer peripheral surface of a can roll as gas discharge ports, and US 3 414 048 A discloses a technique in which grooves are provided in the outer peripheral surface of a can roll as gas discharge ports. Moreover, a method in which a can roll itself is made from a porous body and the small holes in the porous body itself are used as gas discharge ports.

Meanwhile, in methods in which small holes, grooves, or the like are provided in the outer peripheral surface of a can roll as gas discharge ports, the resistance at the gas discharge ports are lower in the region of the outer peripheral surface of the can roll where the film is not wrapped (non-wrapped portion region) than in the region where the film is wrapped (wrapped portion region). This sometimes leads to a situation where the gas supplied to the can roll is mostly discharged to the space in the vacuum chamber from the gas discharge ports in the non-wrapped portion region, which results in a failure to supply the amount of gas that is supposed to be introduced into the gap regions between the outer peripheral surface of the can roll and the film wrapped thereon, and thus makes it impossible to achieve the thermal conductivity enhancing effect mentioned above.

To solve this problem, methods have been proposed such as: a method in which valves that project from the outer peripheral surface of a can roll are provided in gas discharge ports, and the gas discharge ports are opened by pressing a film surface against the respective valves (see US 3 414 048 A); and a method in which a cover is attached to the region of the outer peripheral surface of a can roll where a film is not wrapped, starting from an outfeed point at which the film is outfed and ending at an infeed point at which the film is infed (the non-wrapped portion region of the outer peripheral surface of the can roll) to thereby prevent discharge of a gas from the non-wrapped portion region to the space in the vacuum chamber and thus efficiently introduce the gas into the gap regions between the outer peripheral surface of the can roll and the film surface (see WO 2002/070778 A1).

However, with the method of US 3 414 048 A, in which the gas discharge ports are opened by pressing the film surface against the respective valves projecting from the outer peripheral surface of the can roll, there is a possibility that the film surface is slightly damaged or dented by its contact with the valves. Thus, it is difficult to employ the method of US 3 414 048 A for manufacturing flexible wiring substrates for electronic devices that are required to have high quality. Also, with the method of WO 2002/070778 A1, in which a cover is attached to the region of the outer peripheral surface of a can roll where a film is not wrapped (non-wrapped portion region), gas is likely to leak from the clearance between the cover and the outer peripheral surface of the can roll in a treatment apparatus that performs deposition under high vacuum. Thus, like the method of US 3 414 048 A, it is difficult to employ the method of WO 2002/070778 A1. Further relevant prior art is disclosed in the document JP 2017 043822 A.

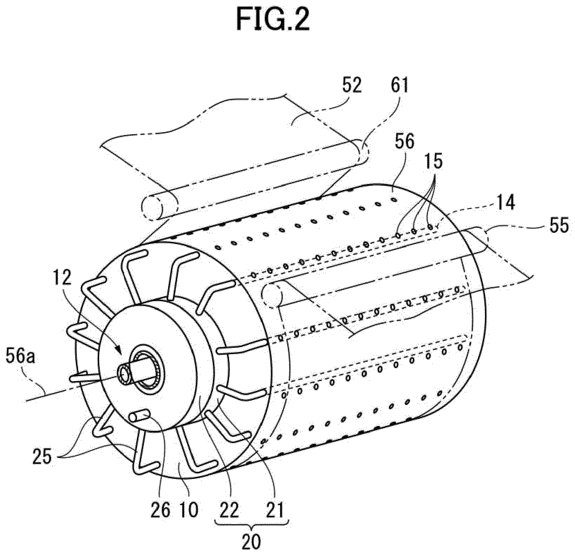

Under these technical circumstances, the present inventor has already proposed a can roll with a structure that does not supply a gas to the outer peripheral surface of the can roll where a film is not wrapped to thereby prevent discharge of the gas from the non-wrapped portion region (see JP 2012 132081 A). Specifically, as illustrated in FIG. 2, this can roll is a can roll 56 provided with a plurality of gas introduction channels 14 in a thick portion of the can roll 56, many gas discharge holes 15 are provided in each gas introduction channel 14, and the can roll 56 is controlled so as to supply a gas from outside the vacuum chamber selectively to the gas introduction channels 14 through a rotary joint 20 described below. Here, as illustrated in FIG. 2, the rotary joint 20 includes a fixed ring unit 22 and a rotary ring unit 21, and there are a can roll fabricated such that each unit's gas control sliding contact surface is formed perpendicularly to a center axis 56a of the can roll 56, and a can roll fabricated such that each unit's gas control sliding contact surface is formed in parallel to the center axis 56a.

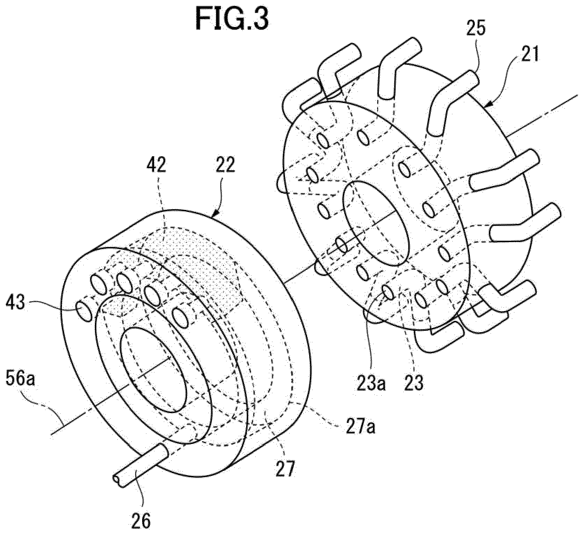

Further, as illustrated in FIGS. 3 to 5, the rotary ring unit 21 of the can roll whose fixed ring unit 22 and rotary ring unit 21 include gas control sliding contact surfaces formed perpendicularly to the center axis 56a of the can roll 56 includes a plurality of gas supply channels 23 that communicate with a plurality of gas introduction channels 14 through connection pipes 25, respectively. Moreover, each of the plurality of gas supply channels 23 includes a revolving opening portion 23a at the gas control sliding contact surface, the revolving opening portion 23a opening at an angular position corresponding to the angular position, on the outer peripheral surface of the can roll 56, of the gas introduction channel 14 communicating with the gas supply channel 23 through the corresponding gas supply channel 25 (i.e., an angular position substantially the same as the angular position on the outer peripheral surface of the can roll 56). On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the gas control sliding contact surface of the fixed ring unit so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. The fixed opening portion opens within an angular range in a region on the gas control sliding contact surface of the fixed ring unit 22 which the revolving opening portions 23a of the rotary ring unit 21 face, the angular range being a range within which a film (long substrate) 52 is wrapped. Note that reference sign 43 in FIGS. 3 to 5 denotes a packing attachment member.

Further, as illustrated in FIG. 3, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside a vacuum chamber 50 is not supplied to the gas supply channels 23. Hence, the gas is not discharged from the gas discharge holes 15 in the outer peripheral surface of the can roll 56. Also, as illustrated in FIG. 3, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

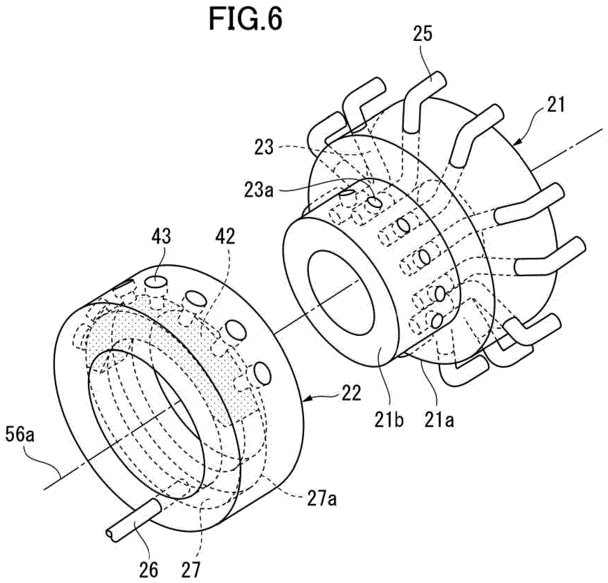

On the other hand, as illustrated in FIGS. 6 to 8, the rotary joint 20 whose fixed ring unit 22 and rotary ring unit 21 include gas control sliding contact surfaces formed in parallel to the center axis 56a of the can roll 56 includes a rotary ring unit 21 having a T-shaped cross section and including a cylindrical base part 21a and a cylindrical protruding part 21b provided coaxially with the can roll 56, and a cylindrical fixed ring unit 22 in which the cylindrical protruding part 21b of the rotary ring unit 21 is fitted. Further, the rotary ring unit 21 includes a plurality of gas supply channels 23 that communicate with a plurality of gas introduction channels 14 through connection pipes 25, respectively. Moreover, each gas supply channel 23 includes a revolving opening portion 23a at the gas control sliding contact surface of the cylindrical protruding part 21b, the revolving opening portion 23a opening at an angular position corresponding to the angular position, on the outer peripheral surface of the can roll 56, of the gas introduction channel 14 communicating with the gas supply channel 23. Also, the fixed ring unit 22 includes a gas distribution channel 27 formed by an annular recessed groove 27a, including a fixed closed portion and a fixed opening portion, and communicating with a supply pipe 26 outside the vacuum chamber 50, the annular recessed groove 27a being provided in the cylindrical inner peripheral surface of the fixed ring unit 22 so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. The fixed opening portion opens within an angular range in the region on the gas control sliding contact surface of the fixed ring unit 22 which the revolving opening portions 23a of the cylindrical protruding part 21b of the rotary ring unit 21 face, the angular range being a range within which the film (long substrate) 52 is wrapped. Note that reference sign 43 in FIGS. 6 to 8 denotes a packing attachment member.

Further, as illustrated in FIG. 6, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56. Also, as illustrated in FIG. 6, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

In JP 2017 043822 A, the present inventor has proposed a can roll as specified in the preamble of claims 1 and 2, and a long substrate treatment apparatus as specified in the preamble of claim 6. The long substrate treatment apparatus of JP 2017 043822 A has a main supply system and a sub-supply system for making a gas pressure in a gas reservoir space constant.

### SUMMARY OF THE INVENTION

### PROBLEM TO BE SOLVED BY THE INVENTION

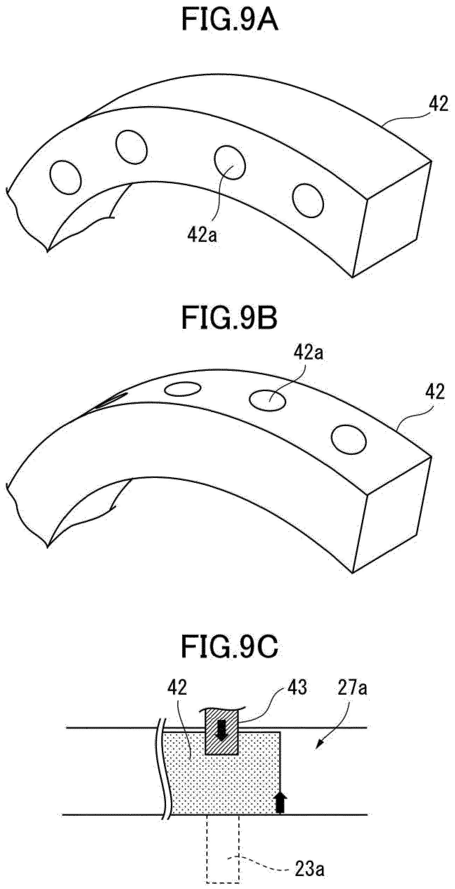

Meanwhile, in the can roll of JP 2012 132081 A including any one of the above rotary joints, the arched packing member 42 to be fitted in the annular recessed groove 27a of the fixed ring unit 22 is made of a fluorine-based resin such as polytetrafluoroethylene. Moreover, as illustrated in FIGS. 9(A) and 9(B), the arched packing member 42 has such an arched shape as to be fitted in the annular recessed groove 27a, and also a plurality of attachment member housing portions 42a in which to fit distal end portions of the packing attachment members 43 are provided in one surface of the arched packing member 42. Note that FIG. 9(A) illustrates the arched packing member employed in the "perpendicular rotary joint" in which the gas control sliding contact surfaces of its rotary ring unit and fixed ring unit are formed perpendicularly to the center axis of the can roll, and FIG. 9(B) illustrates the arched packing member employed in the "parallel rotary joint" in which the gas control sliding contact surfaces of its rotary ring unit and fixed ring unit are formed in parallel to the center axis of the can roll.

Further, as illustrated in FIG. 9(C), the arched packing member 42 is attached in a state of being biased toward the gas control sliding contact surface of the rotary ring unit by using biasing means (not illustrated) of the packing attachment members 43 in order to reliably close the plurality of revolving opening portions 23a, which are provided at the gas control sliding contact surface of the rotary ring unit.

It is, however, not easy to attach the arched packing member 42 in a state where the arched packing member 42 is evenly biased toward the gas control sliding contact surface of the rotary ring unit. If the arched packing member 42 is attached by being strongly pressed toward the gas control sliding contact surface, the arched packing member 42 may be warped and its end sides may float from the gas control sliding contact surface as illustrated in FIG. 9(C). This may cause gas leakage from the revolving opening portions 23a.

Then, if the gas leaks from the revolving opening portions 23a at the gas control sliding contact surface, it will be difficult to control the pressure in the gaps between the surface of the can roll and the film. Consequently, the cooling efficiency may become lower or uneven, which may result in formation of wrinkles on the film during the surface treatment.

The present invention has been made in view of such a problem and an object thereof is to provide a can roll and a long substrate treatment apparatus in which the arched packing member is attached in a state of being evenly biased toward the gas control sliding contact surface of the rotary ring unit.

### MEANS FOR SOLVING THE PROBLEM

To solve the above problem, the present inventor has conducted earnest studies on the shape of the arched packing member. As a result, the present inventor has found that an improvement is achieved by forming end-portion inclined surfaces on the opposite end sides on one surface of the arched packing member facing the gas control sliding contact surface of the rotary ring unit such that the thickness of the packing member gradually increases in the direction toward the gas control sliding contact surface of the rotary ring unit from the longitudinal end sides of the one surface. The present invention has been completed based on such a finding.

That is, a first aspect according to the present invention is a can roll as specified in claim 1.

A second aspect according to the present invention is a can roll as specified in claim 2.

Further developments of the can roll are specified in claims 3 to 5.

A third aspect according to the present invention is a long substrate treatment apparatus as specified in claim 6.

Further developments of the long substrate treatment apparatus are specified in claims 7 to 11.

### EFFECTS OF THE INVENTION

The can roll and the long substrate treatment apparatus according to the present invention employs the arched packing member including the end-portion inclined surfaces on the opposite end sides of the one surface facing the gas control sliding contact surface of the rotary ring unit such that the thickness of the packing member gradually increases in the direction toward the gas control sliding contact surface of the rotary ring unit from the longitudinal end sides of the one surface, and the arched packing member is attached in the annular recessed groove in the fixed ring unit by using packing attachment members.

Further, the arched packing member is attached in the annular recessed groove in a state where the back of the portion of the arched packing member where each end-portion inclined surface is formed and the back of the portion of the arched packing member next to the end-portion inclined surface are pressed by biasing means of the packing attachment members toward the gas control sliding contact surface of the rotary ring unit. Thus, a pressing force is exerted on an inner end portion of the end-portion inclined surface of the arched packing member toward the gas control sliding contact surface. Accordingly, the inner end portion of the end-portion inclined surface of the arched packing member does not float from the gas control sliding contact surface.

Hence, the flat surface of the arched packing member situated inward of the inner end portion of the end-portion inclined surface of the arched packing member can reliably close the revolving opening portions provided at the gas control sliding contact surface of the rotary ring unit.

### BRIEF DESCRIPTION OF THE DRAWINGS

FIG. 1 is an explanatory diagram illustrating an example of a roll-to-roll type long substrate treatment apparatus in which a can roll according to the present invention is preferably used.
FIG. 2 is a schematic perspective view of a can roll according to JP 2012 132081 A including a rotary joint.
FIG. 3 is a schematic perspective view of a fixed ring unit and a rotary ring unit each including a gas control sliding contact surface formed perpendicularly to the center axis of a can roll.
FIG. 4 is an explanatory diagram illustrating a schematic configuration of the can roll in which the gas control sliding contact surfaces of the fixed ring unit and the rotary ring unit are formed perpendicularly to the center axis of the can roll.
FIG. 5 is a side view and A-A' and B-B' cross-sectional views of a rotary joint including the fixed ring unit and the rotary ring unit each including a gas control sliding contact surface formed perpendicularly to the center axis of the can roll.
FIG. 6 is a schematic perspective view of a fixed ring unit and a rotary ring unit each including a gas control sliding contact surface formed in parallel to the center axis of a can roll.
FIG. 7 is an explanatory diagram illustrating a schematic configuration of the can roll in which the gas control sliding contact surfaces of the fixed ring unit and the rotary ring unit are formed in parallel to the center axis of the can roll.
FIG. 8 is a side view and A-A' and B-B' cross-sectional views of a rotary joint including the fixed ring unit and the rotary ring unit each including a gas control sliding contact surface formed in parallel to the center axis of the can roll.
FIGS. 9(A) and 9(B) are schematic partial perspective views of arched packing members according to a conventional example, and FIG. 9(C) is an explanatory diagram illustrating a state where one of the arched packing members is warped and its end sides float from a gas control sliding contact surface when the arched packing member is attached by being strongly pressed toward the gas control sliding contact surface.

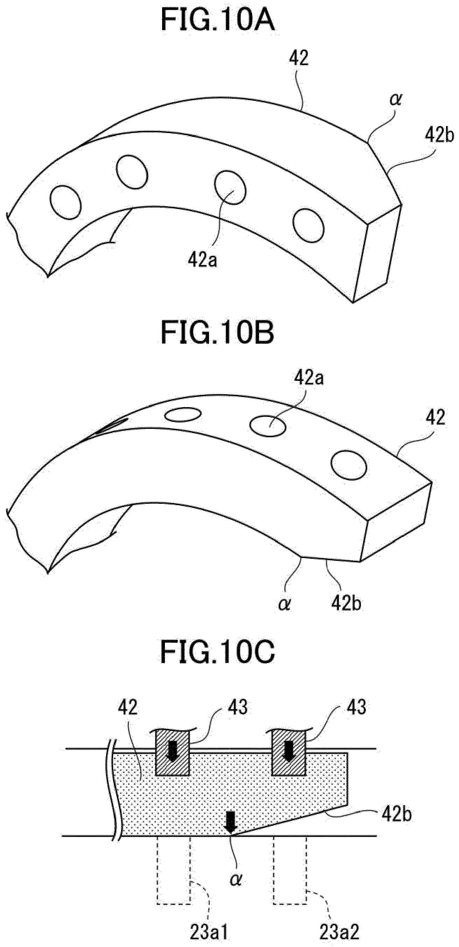

FIGS. 10(A) and 10(B) are schematic partial perspective views of arched packing members according to the present invention which include end-portion inclined surfaces at the opposite end sides, and FIG. 10(C) is an explanatory diagram illustrating a state where a pressing force is exerted on an inner end portion of each end-portion inclined surface toward a gas control sliding contact surface and preventing the inner end portion of the end-portion inclined surface from floating from the gas control sliding contact surface when the arched packing member is attached in a state where the back of the portion of the arched packing member where the end-portion inclined surface is formed and the back of the portion of the arched packing member next to the end-portion inclined surface are pressed toward the gas control sliding contact surface.

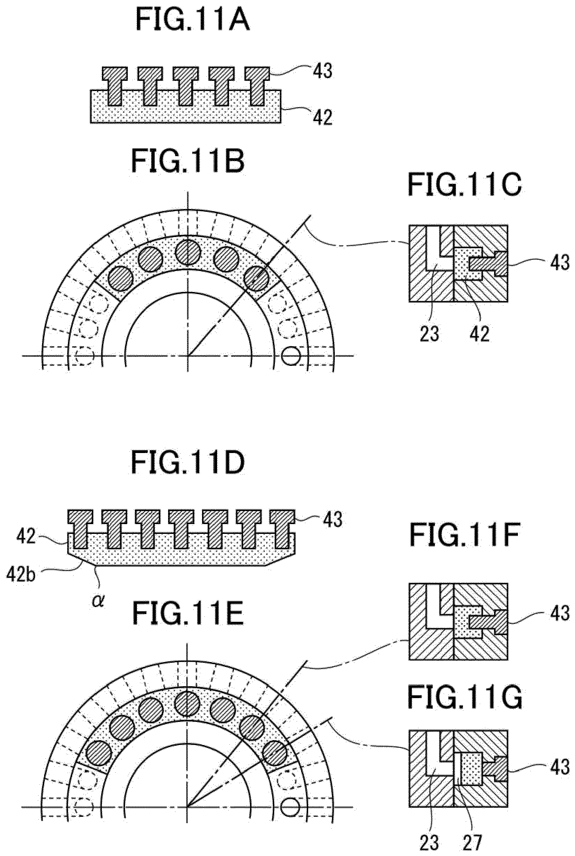

FIG. 11(A) is an explanatory diagram of one of the arched packing members according to the conventional example and packing attachment members, FIG. 11(B) is a partial side view of a perpendicular rotary joint using the arched packing member according to the conventional example and including the fixed ring unit and the rotary unit each including a gas control sliding contact surface formed perpendicularly to the center axis of a can roll, FIG. 11(C) is a partial cross-sectional view of FIG. 11 (B), FIG. 11(D) is an explanatory diagram of one of the arched packing members according to the present invention, which includes the end-portion inclined surfaces on the opposite end sides, and packing attachment members, FIG. 11(E) is a partial side view of a perpendicular rotary joint using the arched packing member according to the present invention and including the fixed ring unit and the rotary unit each including a gas control sliding contact surface formed perpendicularly to the center axis of a can roll, and FIGS. 11(F) and 11(G) are each a partial cross-sectional view of FIG. 11(E).

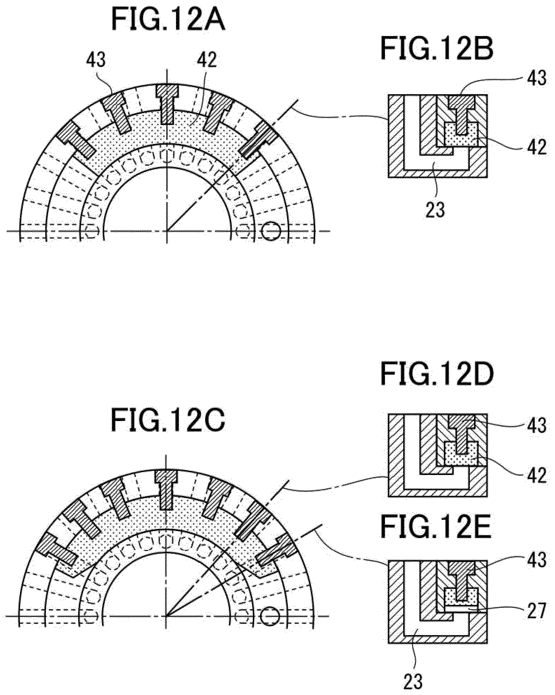

FIG. 12(A) is a partial side view of a parallel rotary joint using one of the arched packing members according to the conventional example and packing attachment members and including the fixed ring unit and the rotary unit each including a gas control sliding contact surface formed in parallel to the center axis of a can roll, FIG. 12(B) is a partial cross-sectional view of FIG. 12 (A), FIG. 12(C) is a partial side view of a parallel rotary joint using one of the arched packing members according to the present invention, which includes the end-portion inclined surfaces on the opposite end sides, and packing attachment members and including the fixed ring unit and the rotary unit each including a gas control sliding contact surface formed in parallel to the center axis of a can roll, and FIGS. 12(D) and 12(E)
are each a partial cross-sectional view of FIG. 12(E).

### MODES FOR PRACTICING THE INVENTION

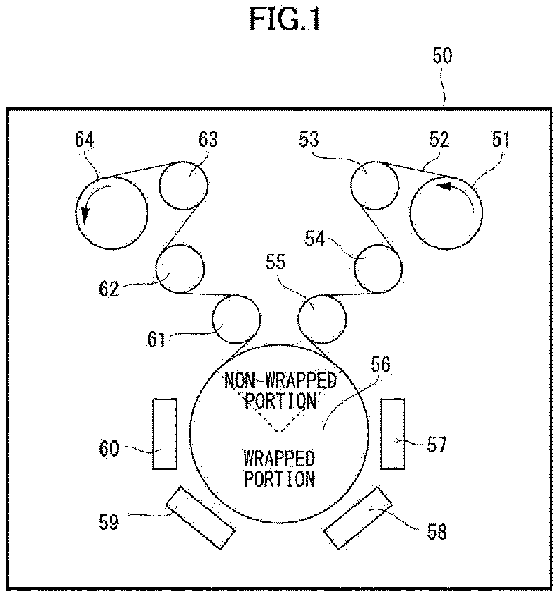

Specific examples of can rolls according to the present invention and a conventional example and long substrate treatment apparatuses equipped with them are specifically described below with reference to the drawings. First, a long substrate vacuum deposition apparatus as an example of a long substrate treatment apparatus is described with reference to FIG. 1. Note that the description is given of a case where a long heat-resistant resin film is used as an example of the long substrate. Also, the description is given by taking a sputtering process as an example of the treatment that applies a thermal load which is to be performed on the long substrate.

### (1) Long Substrate Treatment Apparatus

The long heat-resistant resin film deposition apparatus illustrated in FIG. 1 is an apparatus called a sputtering web coater, and is preferably used to perform a deposition process continuously and efficiently on a surface of a long heat-resistant resin film transferred in a roll-to-roll manner.

Specifically, the deposition apparatus for a long heat-resistant resin film transferred in a roll-to-roll manner (sputtering web coater) is provided in a vacuum chamber 50, and performs a predetermined deposition process on a long heat-resistant resin film 52 unwound from a unwinding roll 51 and then winds up the long heat-resistant resin film 52 with a winding roll 64. A can roll 56 that is rotationally driven by a motor is disposed at a position along the transfer path from the unwinding roll 51 to the winding roll 64. Inside this can roll 56 is circulated a coolant whose temperature is adjusted outside the vacuum chamber 50. Here, the portion of the outer peripheral surface of the can roll 56 on which the film 52 is wrapped is referred to as "wrapped portion" while the portion on which the film 52 is not wrapped is referred to as "non-wrapped portion".

In the vacuum chamber 50, for sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of the vacuum chamber 50 are not particularly limited but various shapes and materials are usable as long as they can withstand the above depressurized state. The vacuum chamber 50 is equipped with various apparatuses not illustrated such as dry pumps, turbomolecular pumps, and cryocoils to depressurize the inside of the vacuum chamber 50 as mentioned above and maintain that state.

A free roller 53 that guides the long heat-resistant resin film 52 and a tension sensor roll 54 that measures the tension of the long heat-resistant resin film 52 are disposed in this order along the transfer path from the unwinding roll 51 to the can roll 56. Also, the long heat-resistant resin film 52 transferred from the tension sensor roll 54 toward the can roll 56 undergoes an adjustment relative to the circumferential speed of the can roll 56 by a motor-driven feed roller 55 provided near the can roll 56. This enables the long heat-resistant resin film 52 to be in tight contact with the outer peripheral surface of the can roll 56.

A motor-driven feed roller 61 that performs an adjustment relative to the circumferential speed of the can roll 56, a tension sensor roll 62 that measures the tension of the long heat-resistant resin film 52, and a free roller 63 that guides the long heat-resistant resin film 52 are disposed in this order along the transfer path from the can roll 56 to the winding roll 64, like the above case.

At the unwinding roll 51 and the winding roll 64, the tension of the long heat-resistant resin film 52 is balanced via torque control with powder clutches or the like. The long heat-resistant resin film 52 is unwound from the unwinding roll 51 and wound up around the winding roll 64 by rotation of the can roll 56 and the motor-driven feed rollers 55 and 61, which rotate according to the can roll 56.

Magnetron sputtering cathodes 57, 58, 59 and 60 as deposition means are positioned near the can roll 56 so as to face the transfer path defined on the outer peripheral surface of the can roll 56 (i.e., the region on the outer peripheral surface of the can roll 56 on which to wrap the long heat-resistant resin film 52). Note that the above-mentioned angular range is referred to the holding angle of the long heat-resistant resin film 52, and this range is referred to as the wrapped portion.

For sputtering deposition of a metal film, plate-shaped targets can be used, as illustrated in FIG. 1. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency.

Also, since the deposition apparatus for the long heat-resistant resin film 52 in FIG. 1 is assumed to perform a sputtering process as the treatment that applies a thermal load, magnetron sputtering cathodes are illustrated. However, in a case where the treatment that applies a thermal load is a different treatment such that CVD (chemical vapor deposition) or a vapor deposition process, different vacuum deposition means is provided in place of the plate-shaped targets.

### (2) Can Roll with Gas Discharge Mechanism

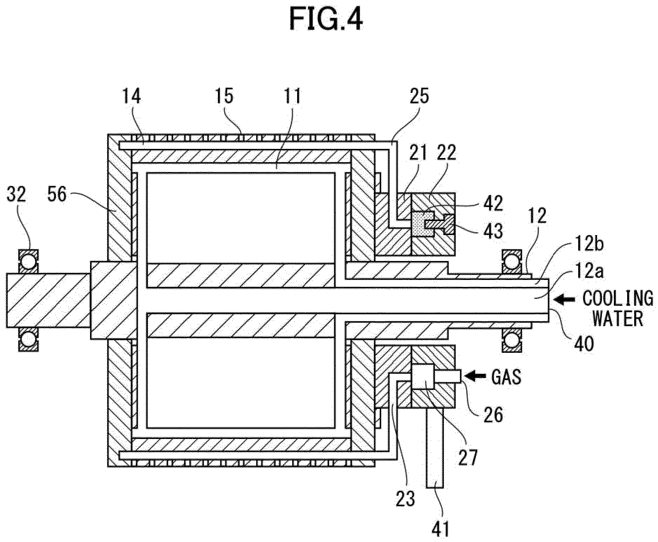

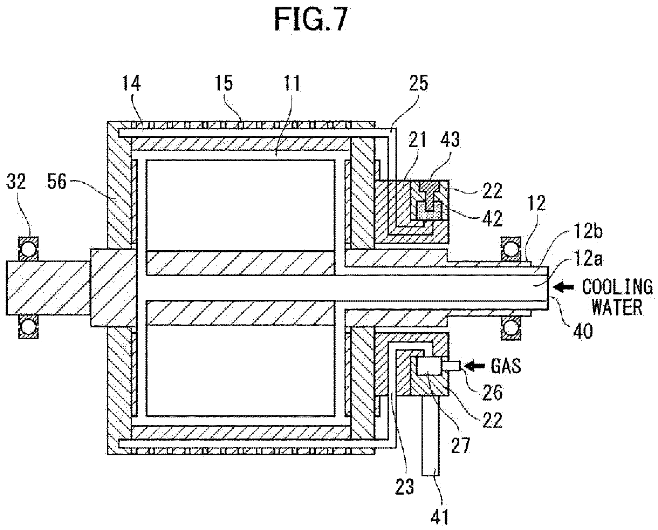

Next, a can roll with a gas discharge mechanism is described with reference to FIGS. 2, 4, and 7. A can roll 56 with a gas discharge mechanism includes a cylindrical member 10 that is rotationally driven about a rotation center axis 56a by a drive apparatus not illustrated (see FIG. 2). On the outer surface of this cylindrical member 10, a transfer path is defined along which to wrap and transfer a long heat-resistant resin film 52. On the inner surface side of the cylindrical member 10, a coolant circulation portion 11 (see FIGS. 4 and 7) with a jacket structure is formed through which a coolant such as cooling water flows.

Also, a rotary shaft 12 (see FIG. 2) situated at the position of the rotation center axis 56a of the cylindrical member 10 has a double-pipe structure, and the coolant circulates between a coolant cooling apparatus not illustrated which is provided outside the vacuum chamber 50 and the coolant circulation portion 11 through this rotary shaft 12. This makes it possible to adjust the temperature of the outer peripheral surface of the can roll 56.

Specifically, the coolant, such as cooling water, cooled by the coolant cooling apparatus is introduced from a cooling water inlet 40 and sent through an inner pipe 12a to the coolant circulation portion 11, at which the coolant receives the heat of the long heat-resistant resin film 52, thereby rising in temperature. Thereafter, the coolant is returned again to the coolant cooling apparatus through a space between the inner pipe 12a and an outer pipe 12b. Note that bearings 32 that support the rotating can roll 56 are provided on the outer side of the outer pipe 12b.

A plurality of gas introduction channels 14 are arranged over the entire circumference of the cylindrical member 10 of this can roll 56 at substantially equal intervals in the circumferential direction. The plurality of gas introduction channels 14 are each bored in a thick portion of the cylindrical member 10 so as to extend along the direction of the rotation center axis 56a of the can roll 56. Note that FIG. 2 illustrates an example where 12 gas introduction channels 14 are arranged over the entire circumference at equal intervals.

Each gas introduction channel 14 includes a plurality of gas discharge holes 15 opening toward the outer surface of the cylindrical member 10 (i.e. the outer peripheral surface of the can roll 56). The plurality of gas discharge holes 15 are bored at substantially equal intervals along the direction of the rotation center axis 56a of the can roll 56. Moreover, as illustrated in FIG. 2, a gas is supplied from outside the vacuum chamber 50 into each gas introduction channel 14 through a rotary joint 20 including a rotary ring unit 21 and a fixed ring unit 22. In this way, the gas can be introduced into the gap regions (clearances) formed between the outer peripheral surface of the can roll 56 and the long heat-resistant resin film 52 wrapped thereon.

As mentioned above, the long heat-resistant resin film 52 and the surface of the can roll 56 are not completely flat surfaces. Then, with a vacuum therein, the gap regions (clearances) are thermally insulated by the vacuum and accordingly lower the heat transfer efficiency. This causes the formation of wrinkles on the heat-resistant resin film 52 by the heat during the sputtering deposition.

Meanwhile, according to "Improvement of Web Condition by the Deposition Drum Design", 2000 Society of Vacuum Coaters, 50th Annual Technical Conference Proceeding (2007), p.749, in a case where the introduced gas is an argon gas, then when the pressure of the introduced gas is 500 Pa and the distance across a gap is approximately 40 µm or shorter, the thermal conductivity in the gap is 250 (W/m²·K). For the can roll with a gas discharge mechanism of the present invention too, the higher the gas pressure in the gaps between the surface of the can roll and the film at the wrapped portion, the higher the thermal conductivity and the higher the film cooling efficiency. However, if the gas pressure is higher than a reaction P = T/R (R: the radius of the can roll) which is a force with which the film is pressed against the can roll under its tension T, the film floats from the can roll, which makes it difficult to control the gas pressure. It is therefore important to control the gas pressure in the gaps between the surface of the can roll and the film. Moreover, accurate pressure control cannot be performed in some cases if the packing member in the rotary joint fails to completely stop the introduction of the gas to the non-wrapped portion.

Description is given below of a "perpendicular rotary joint" in which gas control sliding contact surfaces of its rotary ring unit and fixed ring unit are formed perpendicularly to the center axis of a can roll, and the "parallel rotary joint" in which gas control sliding contact surfaces of its rotary ring unit and fixed ring unit are formed in parallel to the center axis of a can roll.

### (3) Rotary Joint

### (3-1) Perpendicular Rotary Joint

As illustrated in FIGS. 3 to 5, the perpendicular rotary joint includes a rotary ring unit 21 and a fixed ring unit 22 fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface, the revolving opening portion 23a opening at an angular position corresponding to the angular position, on the outer peripheral surface of the can roll 56, of the gas introduction channel 14 communicating with the gas supply channel 23 through the corresponding connection pipe 25 (substantially the same angular position as the angular position on the outer peripheral surface of the can roll 56).

On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the gas control sliding contact surface so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the rotary ring unit 21 face, the angular range being a range within which the long heat-resistant resin film 52 is wrapped.

Further, as illustrated in FIG. 3, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56.

On the other hand, as illustrated in FIG. 3, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

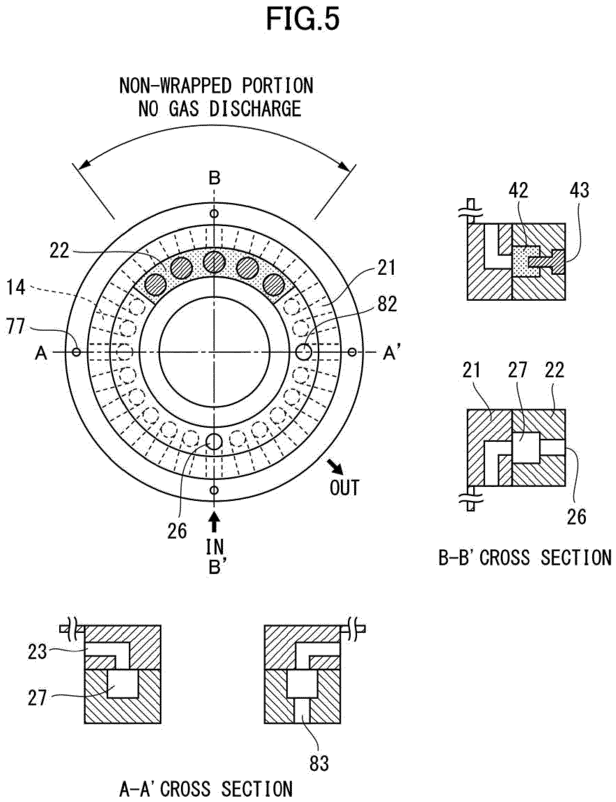

Meanwhile, reference sign 43 in FIGS. 3 to 5 denote a packing attachment member, and reference sign 77 in FIG. 5 denotes a fixing screw hole in the rotary ring unit 21. Also, reference signs 82 and 83 in FIG. 5 denote a pressure gauge port for measuring the pressure in the gas distribution channel 27, which is equal to the gas pressure in the gaps between the outer peripheral surface of the can roll 56 and the film 52 at the wrapped portion region of the surface of the can roll 56, at which the film 52 is wrapped.

### (3-2) Parallel Rotary Joint

As illustrated in FIGS. 6 to 8, the parallel rotary joint includes a rotary ring unit 21 which has a T-shaped cross section and includes a cylindrical base part 21a and a cylindrical protruding part 21b, and a fixed ring unit 22 in which the cylindrical protruding part 21b of the rotary ring unit 21 is fitted and which is fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface of the cylindrical protruding part 21b, the revolving opening portion 23a opening at an angular position corresponding to the angular position, on the outer peripheral surface of the can roll 56, of the gas introduction channel 14 communicating with the gas supply channel 23.

On the other hand, the fixed ring unit 22 includes a gas distribution channel 27 formed by an annular recessed groove 27a, including a fixed closed portion and a fixed opening portion, and communicating with a supply pipe 26 outside the vacuum chamber 50, the annular recessed groove 27a being provided in the cylindrical inner peripheral surface of the fixed ring unit 22 so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the cylindrical protruding part 21b of the rotary ring unit 21 face, the angular range being a range within which the long heat-resistant resin film 52 is wrapped.

Further, as illustrated in FIG. 6, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56.

On the other hand, as illustrated in FIG. 6, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

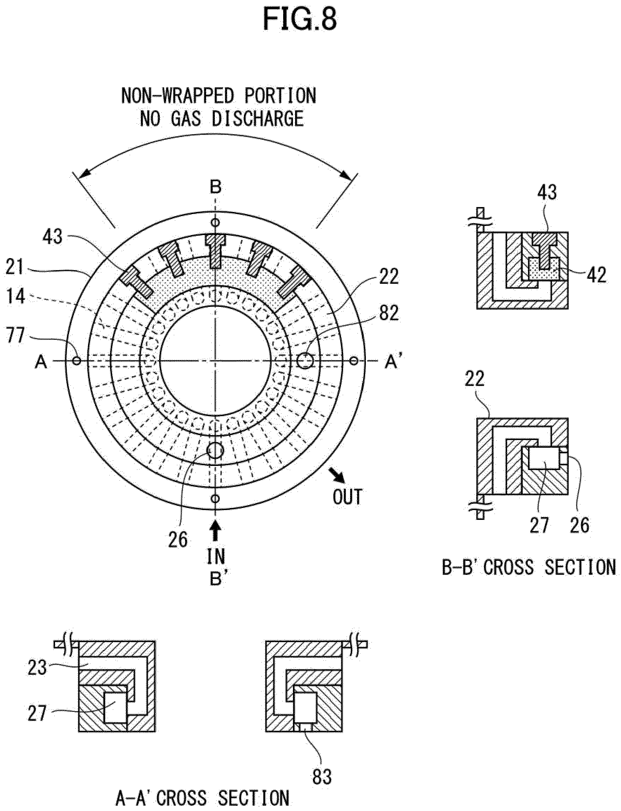

Meanwhile, reference sign 43 in FIGS. 6 to 8 denote a packing attachment member, and reference sign 77 in FIG. 8 denotes a fixing screw hole in the rotary ring unit 21. Also, reference signs 82 and 83 in FIG. 8 denote a pressure gauge port for measuring the pressure in the gas distribution channel 27, which is equal to the gas pressure in the gaps between the outer peripheral surface of the can roll 56 and the film 52 at the wrapped portion region of the surface of the can roll 56, at which the film 52 is wrapped.

### (4) Arched Packing Members

### (4-1) Conventional Arched Packing Members

Moreover, as illustrated in FIGS. 9(A) and 9(B), each of conventional arched packing members 42 to be fitted in the annular recessed groove 27a of the fixed ring unit 22 has such an arched shape as to be fitted in the annular recessed groove 27a, and also a plurality of attachment member housing portions 42a in which to fit distal end portions of packing attachment members incorporating biasing means not illustrated are provided in one surface of the arched packing member 42. Moreover, as illustrated in FIG. 9(C), the arched packing member 42 is attached in the annular recessed groove in a state of being pressed toward the gas control sliding contact surface of the rotary ring unit by the packing attachment members 43 including the biasing means.

It is, however, not easy to attach the conventional arched packing member 42 in a state where the arched packing member 42 is evenly biased toward the gas control sliding contact surface. If the arched packing member 42 is attached by being strongly pressed toward the gas control sliding contact surface, the arched packing member 42 may be warped and its end sides may float from the gas control sliding contact surface as illustrated in FIG. 9(C). This causes gas leakage from the revolving opening portions 23a.

If the gas leaks from the revolving opening portions 23a, it will be difficult to control the pressure in the gaps between the surface of the can roll and the film. Consequently, the cooling efficiency may become lower or uneven, which may result in formation of wrinkles on the long heat-resistant resin film during the surface treatment.

### (4-2) Arched Packing Members According to The Present Invention

As illustrated in FIGS. 10(A) and 10(B), each of the arched packing members 42 according to the present invention has substantially the same structure as that of the conventional arched packing member except that the arched packing member 42 according to the present invention includes end-portion inclined surfaces on the opposite end sides of one surface facing the gas control sliding contact surface of the rotary ring unit such that the thickness of the packing member gradually increases in the direction toward the gas control sliding contact surface of the rotary ring unit from the longitudinal end sides of the one surface. Note that FIG. 10 (A) illustrates the arched packing member employed in the "perpendicular rotary joint", and FIG. 10 (B) illustrates the arched packing member employed in the "parallel rotary joint".

Further, the arched packing member 42 is attached in the annular recessed groove in a state where the back of the portion of the arched packing member 42 where each end-portion inclined surface 42b is formed and the back of the portion of the arched packing member 42 next to the end-portion inclined surface 42b are pressed by the biasing means of packing attachment members 43 toward the gas control sliding contact surface of the rotary ring unit. In this case, a pressing force is exerted on an inner end portion α of the end-portion inclined surface 42b of the arched packing member 42 toward the gas control sliding contact surface, as illustrated in FIG. 10(C). Accordingly, the inner end portion α of the end-portion inclined surface 42b of the arched packing member 42 does not float from the gas control sliding contact surface.

Hence, the flat surface of the arched packing member 42 situated inward of the inner end portion α of the end-portion inclined surface 42b of the arched packing member 42 can reliably close revolving opening portions 23a1 provided at the gas control sliding contact surface of the rotary ring unit.

Note that, as illustrated in FIGS. 11(A) and 11(D) and FIGS. 12(A) and 12(C), the longitudinal dimension of the arched packing member 42 needs to be set larger by the length along which the end-portion inclined surfaces 42b are provided. Moreover, as illustrated in FIG. 10(C), the longitudinal dimension of the end-portion inclined surfaces 42b needs to be set larger than or equal to the predetermined intervals at which the revolving opening portions are provided at the gas control sliding contact surface of the rotary ring unit (see FIG. 11(G) and FIG. 12(E)) so that revolving opening portions 23a2 (corresponding to the wrapped portion region) next to the revolving opening portions 23a1 (corresponding to the non-wrapped portion region) will not be closed by the inner end portions α of the end-portion inclined surfaces 42b.

Meanwhile, in this embodiment, as illustrated in FIG. 10 (C), the structure is such that the arched packing member 42 is attached in the annular recessed groove in the state where the back of the portion of the arched packing member 42 where each end-portion inclined surface 42b is formed and the back of the portion of the arched packing member 42 next to the end-portion inclined surface 42b are pressed by the biasing means of packing attachment members 43 toward the gas control sliding contact surface of the rotary ring unit. The portions of the arched packing member 42 where the end-portion inclined surfaces 42b are formed may be fixed in the annular recessed groove by using fixing means such as screws, and the arched packing member 42 may be attached so as to be biased toward the gas control sliding contact surface of the rotary ring unit by using biasing means provided on the back side of the portion of the arched packing member 42 excluding the portions where the end-portion inclined surfaces 42b are formed and situated inward of the end-portion inclined surfaces 42b. By being attached in this manner, the arched packing member 42 can be biased by the biasing means to be in contact with the gas control sliding contact surface of the rotary ring unit and thus close the revolving opening portions 23a1 at the non-wrapped portion even if the arched packing member 42 wears due to the contact with the gas control sliding contact surface of the rotary ring unit.

Further, in a case where the introduced gas is the same as the gas in the sputtering atmosphere, the sputtering atmosphere will not be contaminated by the introduced gas. Note that the rotary joint may be attached not only on one side of the can roll but on both sides of the can roll, and is preferably attached on both sides of the can roll to stabilize the gas pressure.

### (5) Long Substrate and Surface Treatment That Applies Thermal Load

The long substrate treatment apparatus according to the present invention has been described by taking a heat-resistant resin film as an example of the long substrate. However, other resin films, as a matter of course, and also metal films such as metal foils and metal strips are also usable as the long substrate used in the long substrate treatment apparatus according to the present invention. Examples of the resin films may include resin films with relatively poor heat resistance such as a polyethylene terephthalate (PET) film and heat-resistant resin films such as a polyimide film.

In the case of fabricating the metal film-coated heat-resistant resin film mentioned above, a heat-resistant resin film selected from among a polyimide-based film, a polyamide-based film, a polyester-based film, a polytetrafluoroethylene-based film, a polyphenylene sulfide-based film, a polyethylene naphthalate-based film, and a liquid-crystal polymer-based film is preferably used. This is because a metal film-coated heat-resistant resin film obtained using any of these is superior in flexibility required for metal film-coated flexible substrates, strength necessary to practical use, and electrical insulation performance preferable as a wiring material.

Also, a metal film-coated heat-resistant resin film can be manufactured by applying the above heat-resistant resin film as the long substrate to the above long substrate vacuum deposition apparatus and performing sputtering deposition of metal films on the surface of the heat-resistant resin film. For example, by processing the heat-resistant resin film by a metallizing method using the above deposition apparatus (sputtering web coater), a long metal film-coated heat-resistant resin film can be obtained which is the heat-resistant resin film with a film made of an Ni-based alloy or the like and a Cu film laminated on the surface of the heat-resistant resin film.

After the deposition process, the above metal film-coated heat-resistant resin film is sent to a further process, in which the metal film-coated heat-resistant resin film is processed by a subtractive method into a flexible wiring substrate including a predetermined wiring pattern. Here, the subtractive method refers to a method of manufacturing a flexible wiring substrate by removing a metal film not covered by a resist (e.g. the above Cu film) by etching.

The above film made of an Ni-based alloy or the like is called a seed layer, and its composition is selected as appropriate based on properties required for the metal film-coated heat-resistant resin film such as electric insulation performance and migration resistance. Generally, however, it is made of a publicly known alloy such as an Ni-Cr alloy, Inconel, constantan, or Monel. Note that a wet plating method is sometimes used in a case where a metal film (Cu film) of the metal film-coated long heat-resistant resin film is desired to be thicker. In this case, used is a method in which the metal film is formed by only an electroplating process or a method in which a combination of wet plating processes such as an electroless plating process as primary plating and an electrolytic plating process as secondary plating. For the above wet plating processes, general wet plating conditions can be employed.

Note that the description has been given by taking, as an example, a metal film-coated heat-resistant resin film obtained by laminating films of metals such as an Ni-Cr alloy and Cu on a long heat-resistant resin film. However, it is also possible to use the present invention to form films other than the above metal films such as oxide films, nitride films, and carbide films in accordance with the purpose.

Also, the long substrate treatment apparatus according to the present invention has been described by taking a long substrate vacuum deposition apparatus as an example. However, the above long substrate treatment apparatus also covers treatments that apply a thermal load such as plasma treatment and ion beam treatment, besides vacuum deposition such as sputtering performed on a long substrate inside a vacuum chamber under a depressurized atmosphere. While these plasma treatment and ion beam treatment modify the surface of a long substrate, these apply a thermal load to the long substrate. The the can roll according to the present invention and the long substrate treatment apparatus using this can roll is applicable to these cases and can prevent formation of wrinkles on the long substrate due to the thermal load without leaking a large amount of the introduced gas. Examples of the plasma treatment include a method in which a long substrate is processed with an oxygen plasma or nitrogen plasma generated via discharge through a mixed gas of argon and oxygen or a mixed gas of argon and nitrogen under a depressurized atmosphere. Also, the ion beam treatment refers to a treatment in which a plasma discharge is generated in a magnetic field gap where a strong magnetic field is applied, and positive ions in the plasma as an ion beam to a long substrate. Note that a publicly known ion beam source can be used in the ion beam treatment. Also, these plasma treatment and ion beam treatment are both performed under a depressurized atmosphere.

### EXAMPLES

Examples of the present invention are specifically described below.

### [Design of Rotary Joint]

The diameter of the rotary joint (rotary ring unit and fixed ring unit) was set at approximately 400 mm, and the number of connection pipes 25 on the rotary ring unit, connected to (communicating with) the gas introduction channels 14 of the can roll, was set at 36. Thus, gas control at angular intervals of 10° (360°/36 = 10°) was possible.

Also, the feed roller 55, provided on the infeed side of the can roll, was set such that the can roll and the film contacted each other at a 20° angle position, and the feed roller 61, provided on the outfeed side of the can roll, was set such that the can roll and the film contacted each other at a 340° angle position (in other words, the angle across the non-wrapped portion was set at 40°).

Note that 20° was set as the angles on both sides of the angular range of the non-wrapped portion on which gas control could be unstable, and the gas stop angle for the non-wrapped portion (the angle of the fixed closed portion formed by the arched packing member 42 fitted in a predetermined region inside the annular recessed groove 27a forming the gas distribution channel 27 of the fixed ring unit 22) was set at 90° (> 40° (the non-wrapped portion) + 20° × 2 (the unstable portions on both sides)).

Thus, required was a function to close revolving opening portions (as many revolving opening portions as the number of connection pipes 25 were provided at the gas control sliding contact surface of the rotary ring unit) across 90° (nine revolving opening portions) at a maximum with the arched packing member.

Therefore, two types of rotary joints were fabricated which were the "perpendicular rotary joint" illustrated in FIGS. 3 to 5 and the "parallel rotary joint" illustrated in FIGS. 6 to 8.

### [Designs of Arched Packing Members]

In view of slipperiness and durability, a fluorine-based resin (Teflon (registered trademark)) was used as the material of the packing members, and the conventional structure products illustrated in FIGS. 9(A) and 9(B) and the present invention products illustrated in FIGS. 10(A) and 10(B) were prepared. Note that the end-portion inclined surfaces 42b of each present invention product were formed by cutting end portions of the packing member by 1/3 of the thickness of the member into a wedge shape such that the end-portion inclined surfaces 42b would not close the revolving opening portions. Cutting the end portions of the packing member beyond necessity is not preferable since it lowers the rigidity of the packing member. If the rigidity of the end portions of the packing member is lowered, strongly pressing the farthest edges of the packing member with fixing screws (packing attachment members) only warps the edges, which completely eliminates the effect of the packing member.

As for the conventional structure products, as illustrated in FIGS. 11(A) and 11(B) and FIG. 12(A), the packing arch angle was 100°, and the arched packing member was attached in the annular recessed groove 27a, forming the gas distribution channel 27, by using nine fixing screws (packing attachment members) at 10° intervals.

On the other hand, as for the present invention products, as illustrated in FIGS. 11(D) and 11(E) and FIG. 12(C), the packing arch angle was 130°, and the arched packing member was attached in the annular recessed groove 27a by using 13 fixing screws (packing attachment members) at 10° intervals. Note that the 15° portions situated on the opposite end sides of the 130° packing arch angle region were each cut in a wedge shape as described above (i.e., the above-described "end-portion inclined surfaces" were formed).

### [Example]

Long metal film-coated heat-resistant resin films were fabricated using the deposition apparatus (sputtering web coater) illustrated in FIG. 1. As the long heat-resistant resin film (hereinafter, referred to as the film 52), a heat-resistant polyimide film "UPILEX (registered trademark)", manufactured by Ube Industries, Ltd, measuring 500 mm in width, 800 m in length, and 25 µm in thickness was used.

As the can roll 56, a can roll with a gas introduction mechanism having a jacket roll structure as illustrated in FIG. 2 was used. As the cylindrical member 10 of this can roll 56, a stainless cylindrical member measuring 900 mm in diameter and 750 mm in width was used, and hard chromium plating was performed on its outer peripheral surface. 180 gas introduction channels 14 were bored over the entire circumference of a thick portion of this cylindrical member 10 at equal intervals in the circumferential direction, the gas introduction channels 14 measuring 5 mm in inner diameter and extending in parallel to the direction of the rotation axis of the can roll 56. Note that, of the two ends of each gas introduction channel 14, the distal end was formed into a closed bottom so as not to penetrate through the cylindrical member 10.

Each gas introduction channel 14 was provided with 47 gas discharge holes 15 measuring 0.2 mm in inner diameter and opening toward the outer surface of the cylindrical member 10 (i.e. the outer peripheral surface of the can roll 56). These 47 gas discharge holes 15 were arranged at 10-mm intervals in a direction perpendicular to the direction of advance of the film 52 within a region between lines situated 20 mm inward from both sides of the transfer path of the film 52 defined on the outer surface of the cylindrical member 10. Specifically, the gas discharge holes 15 were not provided within 145-mm regions from both sides of the outer peripheral surface of the can roll 56.

As described above, 180 gas introduction channels 14 were arranged over the entire circumference of the cylindrical member 10 at equal intervals in the circumferential direction. It is difficult to directly connect these 180 gas introduction channels 14 to the rotary joint 20. For this reason, sets of five gas introduction channels 14 were connected to branched pipes (not illustrated) and then connected to the ends of the connection pipes 25 on the rotary ring unit 21. Specifically, on the rotary ring unit 21 of the rotary joint 20, 36 connection pipes 25 were formed, as mentioned above, through each of which the gas was introduced collectively for 10°.

As for the metal films formed on the film 52, a Cu film was formed on an Ni-Cr film, which was a seed layer. To do so, an Ni-Cr target was used as the magnetron sputter target 57, and Cu targets were used as the magnetron sputter targets 58, 59, and 60. The tension at each of the unwinding roll 51 and the winding roll 64 was 200 N. The can roll 56 was controlled at 20°C by water cooling. Here, a cooling effect cannot be expected be achieved without a good efficiency of heat transfer between the film 52 and the can roll 56.

The film 52 in a rolled up state was set on the unwinding roll 51 side of this deposition apparatus, and one end of the film 52 was attached to the winding roll 64 through the can roll 56. In this state, the air in the vacuum chamber 50 was evacuated to 5 Pa by using a plurality of dry pumps and evacuated further to 3 × 10⁻³ Pa by using a plurality of turbomolecular pumps and cryocoils.

Then, with a diaphragm gauge attached to the pressure gauge port 82, 83 in the rotary joint attached to the can roll 56, the flow rate of the argon gas from the supply pipe 26 of the fixed ring unit 22 was controlled such that the gas pressure in the gaps between the surface of the can roll and the film 52 could be 800Pa, while the rotational drive apparatus was actuated to transfer the film at a transfer speed of 3 m/min. The gas flow rate in this state was approximately 20 sccm. Then, the supply of the argon gas and the film transfer were stopped at the same time. If the revolving opening portions 23a at the non-wrapped portion were completely closed by the arched packing member provided in the fixed ring unit 22 of the rotary joint and thus not leaking the gas, the pressure was supposed to hardly drop since the gas discharge holes 15 at the wrapped portion were closed by the film 52. The pressure drops are listed in table 1 below.

**Table 1**

| Rotary Joint | Arched Packing Member | Initial Pressure (Pa) | Pressure (Pa) after 1 Minute | Pressure (Pa) after 2 Minutes | Pressure (Pa) after 3 Minutes |
|---|---|---|---|---|---|
| Perpendicular | Conventional Structure Product | 800 | 400 | 10 | 10 |
| | Present Invention Product | 800 | 750 | 700 | 600 |
| Parallel | Conventional Structure Product | 800 | 400 | 10 | 10 |
| | Present Invention Product | 800 | 750 | 700 | 600 |

From the results in table 1, it is observed that the pressure drop is significant with both the "perpendicular rotary joint" and the "parallel rotary joint" employing the conventional structure products as the arched packing members.

### [Deposition Tests]

Then, deposition tests were conducted on the two types of rotary joints being the "perpendicular rotary joint" and the "parallel rotary joint" by using the conventional structure products and the present invention products as the arched packing members.

An argon gas was introduced at 300 sccm and also electric power control was performed to apply an electric power of 10 kW to the magnetron sputter cathodes 57, 58, 59, and 60. Further, with a diaphragm gauge attached to the pressure gauge port 82, 83 in the rotary joint mounted to the can roll 56, the flow rate of the argon gas from the supply pipe 26 of the fixed ring unit 22 was controlled such that the gas pressure in the gaps between the surface of the can roll and the film could be 800Pa.

The gas flow rate in this state was around 40 sccm and unstable when the conventional structure products were employed as the arched packing members, but was stable at approximately 20 sccm when the present invention products were employed as the arched packing members.

A treatment of continuously depositing a seed layer made of an Ni-Cr film and a Cu film to be deposited on the seed layer was started under the above conditions on one surface of the film 52 transferred in a roll-to-roll manner.

While this treatment was performed, the surface of the film 52 on the can roll 56, into which the gas was being introduced, was observed through a window through which the surface of the film 52 on the can roll 56 in the middle of the deposition could be observed. Film wrinkles due to the thermal load were observed on the film 52 immediately after the deposition that had passed the deposition zone with the magnetron sputtering cathodes 57, 58, 59, and 60.

**Table 2**

| Rotary Joint | Arched Packing Member | Formation of Film Wrinkles |
|---|---|---|
| Perpendicular | Conventional Structure Product | Formed |
| | Present Invention Product | Not Formed |
| Parallel | Conventional Structure Product | Formed |
| | Present Invention Product | Not Formed |

### [Observation]

From the results in tables 1 and 2, it is observed that both the "perpendicular rotary joint" and the "parallel rotary joint" employing the present invention products as the arched packing members can stop gas leakage at the non-wrapped portion and achieve a stable cooling effect.

### POSSIBILITY OF INDUSTRIAL APPLICATION

The can roll with a gas discharge mechanism according to the present invention can prevent gas leakage at the non-wrapped portion. The present invention therefore is industrially applicable as a manufacturing apparatus and manufacturing method for copper-laminated resin films (metal film-coated heat-resistant resin films) for use as flexible wiring substrates in liquid crystal televisions, mobile phones, and so on.

### REFERENCE SIGNS LIST

α inner end portion
10 cylindrical member
11 coolant circulation portion
12 rotary shaft
12a inner pipe
12b outer pipe
14 gas introduction channel
15 gas discharge hole
20 rotary joint
21 rotary ring unit
21a cylindrical base part
21b cylindrical protruding part
22 fixed ring unit
23 gas supply channel
23a revolving opening portion
23a1 revolving opening portion (corresponding to non-wrapped portion region)
23a2 revolving opening portion (corresponding to wrapped portion region)
25 connection pipe
26 supply pipe
27 gas distribution channel
27a annular recessed groove
32 bearing
40 cooling water inlet
41 fixing member
42 arched packing member
42a attachment member housing portion
42b end-portion inclined surface
43 packing attachment member
44 gas introduction channel
50 vacuum chamber
51 unwinding roller
52 long heat-resistant resin film (long substrate)
53, 63 free roller
54, 62 tension sensor roll
55, 61 feed roller
56 can roll
56a center axis
57, 58, 59, 60 magnetron sputtering cathode
64 winding roll
77 fixing screw hole in rotary ring unit
82 pressure gauge port
83 pressure gauge port

## Claims

1. A can roll (56) that comprises a coolant circulation portion (11) in which a coolant circulates, a plurality of gas introduction channels (14) arranged over an entire circumference of the can roll (56) at substantially equal intervals in a circumferential direction, and a rotary joint (20) which supplies a gas from outside a vacuum chamber (50) to each of the plurality of gas introduction channels (14), and that cools a long substrate (52) transferred through the vacuum chamber (50) in a roll-to-roll manner by having the long substrate (52) wrapped on part of an outer peripheral surface of the can roll (56), wherein
each of the plurality of gas introduction channels (14) comprises a plurality of gas discharge holes (15) opening toward the outer peripheral surface at substantially equal intervals along a direction of a rotation axis of the can roll (56),
the can roll (56) is controlled such that the rotary joint (20) supplies the gas to the gas introduction channels (14) situated within an angular range within which the long substrate (52) is wrapped, and does not supply the gas to the gas introduction channels (14) not situated within the angular range within which the long substrate (52) is wrapped,
the rotary joint (20) comprises a rotary ring unit (21) and a fixed ring unit (22) provided coaxially with the can roll (56) and each comprising a gas control sliding contact surface formed perpendicularly to a center axis (56a) of the can roll (56),
the rotary ring unit (21) comprises a plurality of gas supply channels (23) communicating with the plurality of gas introduction channels (14), respectively, the plurality of gas supply channels (23) each comprising a revolving opening portion (23a) at the gas control sliding contact surface of the rotary ring unit (21), the revolving opening portion (23a) opening at an angular position corresponding to an angular position, on the outer peripheral surface of the can roll (56), of the gas introduction channel (14) communicating with the gas supply channel (23),
the fixed ring unit (22) comprises a gas distribution channel (27) formed by an annular recessed groove (27a), comprising a fixed opening portion, and communicating with a supply pipe (26) outside the vacuum chamber (50), the annular recessed groove (27a) being provided in the gas control sliding contact surface of the fixed ring unit (22) so as to extend in the circumferential direction, the fixed opening portion opening within an angular range in a region on the gas control sliding contact surface of the fixed ring unit (22) which the revolving opening portions (23a) of the rotary ring unit (21) face, the angular range being a range within which the long substrate (52) is wrapped,
**characterized in that**
the gas distribution channel (27) further comprises a fixed closed portion, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed,
the arched packing member (42), which is fitted in the predetermined region inside the annular recessed groove (27a), comprises end-portion inclined surfaces (42b) on opposite end sides of one surface facing the gas control sliding contact surface of the rotary ring unit (21) such that thickness of the arched packing member (42) gradually increases in a direction toward the gas control sliding contact surface of the rotary ring unit (21) from longitudinal end sides of the one surface, and
the arched packing member (42) is attached in the annular recessed groove (27a) in a state where the back of the portion of the arched packing member (42) where each end-portion inclined surface (42b) is formed and the back of the portion of the arched packing member (42) next to the end-portion inclined surface (42b) are pressed by biasing means of packing attachment members (43) toward the gas control sliding contact surface of the rotary ring unit (21).

2. A can roll (56) that comprises a coolant circulation portion (11) in which a coolant circulates, a plurality of gas introduction channels (14) arranged over an entire circumference of the can roll (56) at substantially equal intervals in a circumferential direction, and a rotary joint (20) which supplies a gas from outside a vacuum chamber (50) to each of the plurality of gas introduction channels (14), and that cools a long substrate (52) transferred through the vacuum chamber (50) in a roll-to-roll manner by having the long substrate (52) wrapped on part of an outer peripheral surface of the can roll (56), wherein
each of the plurality of gas introduction channels (14) comprises a plurality of gas discharge holes (15) opening toward the outer peripheral surface at substantially equal intervals along a direction of a rotation axis of the can roll (56),
the can roll (56) is controlled such that the rotary joint (20) supplies the gas to the gas introduction channels (14) situated within an angular range within which the long substrate (52) is wrapped, and does not supply the gas to the gas introduction channels (14) not situated within the angular range within which the long substrate (52) is wrapped,
**characterized in that**
the rotary joint (20) comprises a rotary ring unit (21) having a T-shaped cross section and comprising a cylindrical base part (21a) and a cylindrical protruding part (21b) provided coaxially with the can roll (56), and a cylindrical fixed ring unit (22) in which the cylindrical protruding part (21b) of the rotary ring unit (21) is fitted such that the cylindrical protruding part (21b) and the fixed ring unit (22) each comprises a gas control sliding contact surface formed in parallel to a center axis (56a) of the can roll (56),
the rotary ring unit (21) comprises a plurality of gas supply channels (23) communicating with the plurality of gas introduction channels (14), respectively, the plurality of gas supply channels (23) each comprising a revolving opening portion (23a) at the gas control sliding contact surface of the cylindrical protruding part (21b) of the rotary ring unit (21), the revolving opening portion (23a) opening at an angular position corresponding to an angular position, on the outer peripheral surface of the can roll (56), of the gas introduction channel (14) communicating with the gas supply channel (23),
the fixed ring unit (22) comprises a gas distribution channel (27) formed by an annular recessed groove (27a), comprising a fixed closed portion and a fixed opening portion, and communicating with a supply pipe (26) outside the vacuum chamber (50), the annular recessed groove (27a) being provided in a cylindrical inner circumferential surface of the fixed ring unit (22) so as to extend in the circumferential direction, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed, the fixed opening portion opening within an angular range in a region on the gas control sliding contact surface of the fixed ring unit (22) which the revolving opening portions (23a) of the cylindrical protruding part (21b) of the rotary ring unit (21) face, the angular range being a range within which the long substrate (52) is wrapped,
the arched packing member (42), which is fitted in the predetermined region inside the annular recessed groove (27a), comprises end-portion inclined surfaces (42b) on opposite end sides of one surface facing the gas control sliding contact surface of the rotary ring unit (21) such that thickness of the arched packing member (42) gradually increases in a direction toward the gas control sliding contact surface of the rotary ring unit (21) from longitudinal end sides of the one surface, and
the arched packing member (42) is attached in the annular recessed groove (27a) in a state where the back of the portion of the arched packing member (42) where each end-portion inclined surface (42b) is formed and the back of the portion of the arched packing member (42) next to the end-portion inclined surface (42b) are pressed by biasing means of packing attachment members (43) toward the gas control sliding contact surface of the rotary ring unit (21).

3. The can roll (56) according to claim 1 or 2, wherein a longitudinal dimension of the end-portion inclined surfaces (42b), which are formed on opposite longitudinal end sides of the arched packing member (42), is set larger than or equal to a predetermined interval at which the revolving opening portions (23a) are provided at the gas control sliding contact surface of the rotary ring unit (21).

4. The can roll (56) according to any one of claims 1 to 3, wherein
opposite longitudinal end sides of the arched packing member (42) where the end-portion inclined surfaces (42b) are formed are fixed in the annular recessed groove (27a) by using fixing means, and
a portion of the arched packing member (42) other than the opposite longitudinal end sides is attached so as to be biased toward the gas control sliding contact surface of the rotary ring unit (21) by using the biasing means provided on the back side of the arched packing member (42).

5. The can roll (56) according to any one of claims 1 to 4, wherein the arched packing member (42) is made of a fluorine-based resin.

6. A long substrate treatment apparatus comprising:
a vacuum chamber (50);
a transfer mechanism that transfers a long substrate (52) through the vacuum chamber (50) in a roll-to-roll manner;
treatment means (57, 58, 59, 60) for performing a treatment that applies a thermal load on the long substrate (52); and
a can roll (56) that cools the long substrate (52) by having the long substrate (52) wrapped on part of an outer peripheral surface of the can roll (56) cooled by circulating coolant,
**characterized in that**
the can roll (56) is the can roll (56) according to any one of claims 1 to 5.

7. The long substrate treatment apparatus according to claim 6, wherein the treatment that applies a thermal load is a plasma treatment or an ion beam treatment.

8. The long substrate treatment apparatus according to claim 7, wherein a mechanism that performs the plasma treatment or the ion beam treatment faces a transfer path defined on the outer peripheral surface of the can roll (56).

9. The long substrate treatment apparatus according to claim 6, wherein the treatment that applies a thermal load is a vacuum deposition treatment.

10. The long substrate treatment apparatus according to claim 9, wherein the vacuum deposition treatment is a treatment with vacuum deposition means facing a transfer path defined on the outer peripheral surface of the can roll (56).

11. The long substrate treatment apparatus according to claim 10, wherein the vacuum deposition means is magnetron sputtering.

## Patentansprüche

1. Dosenrolle (56), die einen Kühlmittelzirkulationsabschnitt (11), in dem ein Kühlmittel zirkuliert, eine Vielzahl von Gaseinleitungskanälen (14), die in einer Umfangsrichtung über einen Gesamtumfang der Dosenrolle (56) in im Wesentlichen gleichen Abständen angeordnet sind, und eine Drehverbindung (20), die jedem der Vielzahl von Gaseinleitungskanälen (14) ein Gas von außerhalb einer Vakuumkammer (50) zuführt, umfasst und die ein Langsubstrat (52) kühlt, das von Rolle zu Rolle durch die Vakuumkammer (50) transportiert wird, indem sie das Langsubstrat (52) auf einem Teil einer Außenumfangsfläche der Dosenrolle (56) aufgewickelt hat, wobei
jeder der Vielzahl von Gaseinleitungskanälen (14) eine Vielzahl von Gasausstoßlöchern (15) umfasst, die sich in im Wesentlichen gleichen Abständen entlang einer Richtung einer Drehachse der Dosenrolle (56) in Richtung der Außenumfangsfläche öffnen,
die Dosenrolle (56) derart gesteuert wird, dass die Drehverbindung (20) das Gas den Gaseinleitungskanälen (14) zuführt, die sich innerhalb eines Winkelbereichs befinden, innerhalb dessen das Langsubstrat (52) aufgewickelt ist, und das Gas nicht den Gaseinleitungskanälen (14) zuführt, die sich nicht innerhalb des Winkelbereichs befinden, innerhalb dessen das Langsubstrat (52) aufgewickelt ist,
die Drehverbindung (20) eine Drehringeinheit (21) und eine Festringeinheit (22) umfasst, die koaxial zur Dosenrolle (56) vorgesehen sind und jeweils eine Gassteuerungsgleitkontaktfläche umfassen, die senkrecht zu einer Mittelachse (56a) der Dosenrolle (56) ausgebildet ist,
die Drehringeinheit (21) eine Vielzahl von Gaszufuhrkanälen (23) umfasst, die jeweils mit der Vielzahl von Gaseinleitungskanälen (14) in Verbindung stehen, wobei die Vielzahl von Gaszufuhrkanälen (23) an der Gassteuerungsgleitkontakfläche der Drehringeinheit (21) jeweils einen umlaufenden sich öffnenden Abschnitt (23a) umfasst und sich der umlaufende sich öffnende Abschnitt (23a) an einer Winkelposition öffnet, die einer Winkelposition des mit dem Gaszufuhrkanal (23) in Verbindung stehenden Gaseinleitungskanals (14) auf der Außenumfangsfläche der Dosenrolle (56) entspricht,
die Festringeinheit (22) einen Gasverteilungskanal (27) umfasst, der von einer ringförmigen vertieften Nut (27a) ausgebildet wird, der einen festen sich öffnenden Abschnitt umfasst und der mit einem Zufuhrrohr (26) außerhalb der Vakuumkammer (50) in Verbindung steht, wobei die ringförmige vertiefte Nut (27a) so in der Gassteuerungsgleitkontaktfläche der Festringeinheit (22) vorgesehen ist, dass sie sich in der Umfangsrichtung erstreckt, sich der feste sich öffnende Abschnitt in einem Bereich auf der Gassteuerungsgleitkontaktfläche der Festringeinheit (22) innerhalb eines Winkelbereichs öffnet, dem die umlaufenden sich öffnenden Abschnitte (23a) der Drehringeinheit (21) zugewandt sind, und der Winkelbereich ein Bereich ist, innerhalb dessen das Langsubstrat (52) aufgewickelt ist,
**dadurch gekennzeichnet, dass**
der Verteilungskanal (27) außerdem einen festen geschlossenen Abschnitt umfasst, wobei der feste geschlossene Abschnitt ein Abschnitt ist, an dem die Gassteuerungsgleitkontaktfläche der Festringeinheit (22) von einem bogenförmigen Dichtungselement (42) geschlossen wird, das in einem vorbestimmten Bereich innerhalb der ringförmigen vertieften Nut (27a) eingepasst ist, wobei der feste sich öffnende Abschnitt ein Abschnitt ist, an dem die Gassteuerungsgleitkontaktfläche nicht geschlossen ist,
das bogenförmige Dichtungselement (42), das in dem vorbestimmten Bereich innerhalb der ringförmigen vertieften Nut (27a) eingepasst ist, derart Endabschnittsneigungsflächen (42b) auf gegenüberliegenden Endseiten von einer Oberfläche umfasst, die der Gassteuerungsgleitkontaktfläche der Drehringeinheit (21) zugewandt wird, dass die Dicke des bogenförmigen Dichtungselements (42) von Längsendseiten der einen Oberfläche aus allmählich in einer Richtung zur Gassteuerungsgleitkontaktfläche der Drehringeinheit (21) hin zunimmt, und
das bogenförmige Dichtungselement (42) in der ringförmigen vertieften Nut (27a) in einem Zustand angebracht ist, in dem die Rückseite des Abschnitts des bogenförmigen Dichtungselements (42), an dem jede Endabschnittsneigungsfläche (42b) ausgebildet ist, und die Rückseite des Abschnitts neben der Endabschnittsneigungsfläche (42b) durch Vorspannmittel von Dichtungsanbringungselementen (43) in Richtung der Gassteuerungsgleitkontaktfläche der Drehringeinheit (21) gedrückt werden.

2. Dosenrolle (56), die einen Kühlmittelzirkulationsabschnitt (11), in dem ein Kühlmittel zirkuliert, eine Vielzahl von Gaseinleitungskanälen (14), die in einer Umfangsrichtung über einen Gesamtumfang der Dosenrolle (56) in im Wesentlichen gleichen Abständen angeordnet sind, und eine Drehverbindung (20), die jedem der Vielzahl von Gaseinleitungskanälen (14) ein Gas von außerhalb einer Vakuumkammer (50) zuführt, umfasst und die ein Langsubstrat (52) kühlt, das von Rolle zu Rolle durch die Vakuumkammer (50) transportiert wird, indem sie das Langsubstrat (52) auf einem Teil einer Außenumfangsfläche der Dosenrolle (56) aufgewickelt hat, wobei
jeder der Vielzahl von Gaseinleitungskanälen (14) eine Vielzahl von Gasausstoßlöchern (15) umfasst, die sich in im Wesentlichen gleichen Abständen entlang einer Richtung einer Drehachse der Dosenrolle (56) in Richtung der Außenumfangsfläche öffnen,
die Dosenrolle (56) derart gesteuert wird, dass die Drehverbindung (20) das Gas den Gaseinleitungskanälen (14) zuführt, die sich innerhalb eines Winkelbereichs befinden, innerhalb dessen das Langsubstrat (52) aufgewickelt ist, und das Gas nicht den Gaseinleitungskanälen (14) zuführt, die sich nicht innerhalb des Winkelbereichs befinden, innerhalb dessen das Langsubstrat (52) aufgewickelt ist,
**dadurch gekennzeichnet, dass**
die Drehverbindung (20) eine Drehringeinheit (21), die einen T-förmigen Querschnitt hat und die einen zylindrischen Grundteil (21a) und einen zylindrischen vorstehenden Teil (21b) umfasst, die koaxial zur Dosenrolle (56) vorgesehen sind, und eine zylindrische Festringeinheit (22) umfasst, in der der zylindrische vorstehende Teil (21b) der Drehringeinheit (21) derart eingepasst ist, dass der zylindrische vorstehende Teil (21b) und die Festringeinheit (22) jeweils eine Gassteuerungsgleitkontaktfläche umfassen, die parallel zu einer Mittelachse (56a) der Dosenrolle (56) ausgebildet ist,
die Drehringeinheit (21) eine Vielzahl von Gaszufuhrkanälen (23) umfasst, die jeweils mit der Vielzahl von Gaseinleitungskanälen (14) in Verbindung stehen, wobei die Vielzahl von Gaszufuhrkanälen (23) an der Gassteuerungsgleitkontaktfläche des zylindrischen vorstehenden Teils (21b) der Drehringeinheit (21) jeweils einen umlaufenden sich öffnenden Abschnitt (23a) umfasst und sich der umlaufende sich öffnende Abschnitt (23a) an einer Winkelposition öffnet, die einer Winkelposition des mit dem Gaszuführungskanal (23) in Verbindung stehenden Gaseinleitungskanals (14) auf der Außenumfangsfläche der Dosenrolle (56) entspricht,
die Festringeinheit (22) einen Gasverteilungskanal (27) umfasst, der von einer ringförmigen vertieften Nut (27a) ausgebildet wird, der einen festen geschlossenen Abschnitt und einen festen sich öffnenden Abschnitt umfasst und der mit einem Zufuhrrohr (26) außerhalb der Vakuumkammer (50) in Verbindung steht, wobei die ringförmige vertiefte Nut (27a) so in einer zylindrischen Innenumfangsfläche der Festringeinheit (22) vorgesehen ist, dass sie sich in der Umfangsrichtung erstreckt, der feste geschlossene Abschnitt ein Abschnitt ist, an dem die Gassteuerungsgleitkontaktfläche der Festringeinheit (22) von einem bogenförmigen Dichtungselement (42) geschlossen wird, das in einem vorbestimmten Bereich innerhalb der ringförmigen vertieften Nut (27a) eingepasst ist, der feste sich öffnende Abschnitt ein Abschnitt ist, an dem die Gassteuerungsgleitkontaktfläche nicht geschlossen ist, sich der feste sich öffnende Abschnitt in einem Bereich auf der Gassteuerungsgleitkontaktfläche der Festringeinheit (22) innerhalb eines Winkelbereichs öffnet, dem die umlaufenden sich öffnenden Abschnitte (23a) des zylindrischen vorstehenden Teils (21b) der Drehringeinheit (21) zugewandt sind, und der Winkelbereich ein Bereich ist, innerhalb dessen das Langsubstrat (52) aufgewickelt ist,
das bogenförmige Dichtungselement (42), das in dem vorbestimmten Bereich innerhalb der ringförmigen vertieften Nut (27a) eingepasst ist, derart Endabschnittsneigungsflächen (42b) auf gegenüberliegenden Endseiten von einer Oberfläche umfasst, die der Gassteuerungsgleitkontaktfläche der Drehringeinheit (21) zugewandt wird, dass die Dicke des bogenförmigen Dichtungselements (42) von Längsendseiten der einen Oberfläche aus allmählich in einer Richtung zur Gassteuerungsgleitkontaktfläche der Drehringeinheit (21) hin zunimmt, und
das bogenförmige Dichtungselement (42) in der ringförmigen vertieften Nut (27a) in einem Zustand angebracht ist, in dem die Rückseite des Abschnitts des bogenförmigen Dichtungselements (42), an dem jede Endabschnittsneigungsfläche (42b) ausgebildet ist, und die Rückseite des Abschnitts neben der Endabschnittsneigungsfläche (42b) durch Vorspannmittel von Dichtungsanbringungselementen (43) in Richtung der Gassteuerungsgleitkontaktfläche der Drehringeinheit (21) gedrückt werden.

3. Dosenrolle (56) nach Anspruch 1 oder 2, wobei eine Längsabmessung der Endabschnittsneigungsflächen (42b), die auf gegenüberliegenden Längsendseiten des bogenförmigen Dichtungselements (42) ausgebildet sind, größer als oder gleich groß wie ein vorbestimmter Abstand eingestellt ist, in dem die umlaufenden sich öffnenden Abschnitte (23a) an der Gassteuerungsgleitkontaktfläche der Drehringeinheit (21) vorgesehen sind.

4. Dosenrolle (56) nach einem der Ansprüche 1 bis 3, wobei
gegenüberliegende Längsendseiten des bogenförmigen Dichtungselements (42), an denen die Endabschnittsneigungsflächen (42b) ausgebildet sind, unter Verwendung von Befestigungsmitteln in der ringförmigen vertieften Nut (27a) befestigt sind und
ein anderer Abschnitt des bogenförmigen Dichtungselements (42) als die gegenüberliegenden Längsendseiten so angebracht ist, dass er unter Verwendung der Vorspannmittel, die auf der Rückseite des bogenförmigen Dichtungselements (42) vorgesehen sind, in Richtung der Gassteuerungsgleitkontaktfläche der Drehringeinheit (21) vorgespannt wird.

5. Dosenrolle (56) nach einem der Ansprüche 1 bis 4, wobei das bogenförmige Dichtungselement (42) aus einem Harz auf Fluorbasis besteht.

6. Langsubstrat-Behandlungsvorrichtung, die Folgendes umfasst:
eine Vakuumkammer (50);
einen Transportmechanismus, der ein Langsubstrat (52) von Rolle zu Rolle durch die Vakuumkammer (50) transportiert;
Behandlungsmittel (57, 58, 59, 60) zur Durchführung einer Behandlung, die auf das Langsubstrat (52) eine Wärmelast aufbringt; und
eine Dosenrolle (56), die das Langsubstrat (52) kühlt, indem sie das Langsubstrat (52) auf einem Teil einer Außenumfangsfläche der Dosenrolle (56) aufgewickelt hat, die durch zirkulierendes Kühlmittel gekühlt wird, **dadurch gekennzeichnet, dass**
die Dosenrolle (56) die Dosenrolle (56) nach einem der Ansprüche 1 bis 5 ist.

7. Langsubstrat-Behandlungsvorrichtung nach Anspruch 6, wobei die Behandlung, die eine Wärmelast aufbringt, eine Plasmabehandlung oder eine Ionenstrahlbehandlung ist.

8. Langsubstrat-Behandlungsvorrichtung nach Anspruch 7, wobei ein Mechanismus, der die Plasmabehandlung oder die Ionenstrahlbehandlung durchführt, einem Transportweg zugewandt ist, der auf der Außenumfangsfläche der Dosenrolle (56) definiert ist.

9. Langsubstrat-Behandlungsvorrichtung nach Anspruch 6, wobei die Behandlung, die eine Wärmelast aufbringt, eine Vakuumabscheidungsbehandlung ist.

10. Langsubstrat-Behandlungsvorrichtung nach Anspruch 9, wobei die Vakuumabscheidungsbehandlung eine Behandlung mit Vakuumabscheidungsmitteln ist, die einem Transportweg zugewandt sind, der auf der Außenumfangsfläche der Dosenrolle (56) definiert ist.

11. Langsubstrat-Behandlungsvorrichtung nach Anspruch 10, wobei die Vakuumabscheidungsmittel Magnetron-Sputtern sind.

## Revendications

1. Rouleau scellé (56) qui comprend une partie de circulation de liquide de refroidissement (11) dans laquelle circule un liquide de refroidissement, une pluralité de canaux d'introduction de gaz (14) agencés sur toute une circonférence du rouleau scellé (56) à des intervalles sensiblement égaux dans une direction circonférentielle, et un joint rotatif (20) qui alimente un gaz de l'extérieur d'une chambre à vide (50) à chacun de la pluralité des canaux d'introduction de gaz (14), et qui refroidit un long substrat (52) transféré de rouleau à rouleau à travers la chambre à vide (50) en enveloppant le long substrat (52) sur une partie d'une surface périphérique extérieure du rouleau scellé (56), dans lequel
chacun de la pluralité de canaux d'introduction de gaz (14) comprend une pluralité de trous de décharge de gaz (15) s'ouvrant vers la surface périphérique extérieure à des intervalles sensiblement égaux le long d'une direction d'un axe de rotation du rouleau scellé (56),
le rouleau scellé (56) est commandé de telle sorte que le joint rotatif (20) alimente le gaz aux canaux d'introduction de gaz (14) situés dans une plage angulaire dans laquelle le long substrat (52) est enveloppé, et n'alimente pas le gaz aux canaux d'introduction de gaz (14) qui ne sont pas situés dans la plage angulaire dans laquelle le long substrat (52) est enveloppé,
le joint rotatif (20) comprend une unité de bague rotative (21) et une unité de bague fixe (22) prévues coaxialement avec le rouleau scellé (56) et comprenant chacune une surface de contact de coulissement de commande de gaz formée perpendiculairement à un axe central (56a) du rouleau scellé (56),
l'unité de bague rotative (21) comprend une pluralité de canaux d'alimentation en gaz (23) communiquant avec la pluralité de canaux d'introduction de gaz (14), respectivement, la pluralité de canaux d'alimentation en gaz (23) comprenant chacun une partie d'ouverture tournante (23a) sur la surface de contact de coulissement de commande de gaz de l'unité de bague rotative (21), la partie d'ouverture tournante (23a) s'ouvrant à une position angulaire correspondant à une position angulaire, sur la surface périphérique extérieure du rouleau scellé (56), du canal d'introduction de gaz (14) communiquant avec le canal d'alimentation en gaz (23),
l'unité de bague fixe (22) comprend un canal de distribution de gaz (27) formé par une rainure annulaire en creux (27a), comprenant une partie d'ouverture fixe, et communiquant avec un tuyau d'alimentation (26) à l'extérieur de la chambre à vide (50), la rainure annulaire en creux (27a) étant prévue dans la surface de contact de coulissement de commande de gaz de l'unité de bague fixe (22) de manière à s'étendre dans la direction circonférentielle, la partie d'ouverture fixe s'ouvrant dans une plage angulaire dans une région sur la surface de contact de coulissement de commande de gaz de l'unité de bague fixe (22) à laquelle font face les parties d'ouverture tournantes (23a) de l'unité de bague rotative (21), la plage angulaire étant une plage dans laquelle le long substrat (52) est enveloppé,
**caractérisé en ce que**
le canal de distribution de gaz (27) comprend en outre une partie fermée fixe, la partie fermée fixe étant une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe étant une partie au niveau de laquelle la surface de contact de coulissement de commande de gaz n'est pas fermée,
l'élément de garniture arqué (42), qui est ajusté dans la région prédéterminée à l'intérieur de la rainure annulaire en creux (27a), comprend des surfaces inclinées de partie d'extrémité (42b) sur des côtés d'extrémité opposés d'une surface faisant face à la surface de contact de coulissement de commande de gaz de l'unité de bague rotative (21) de sorte que l'épaisseur de l'élément de garniture arqué (42) augmente progressivement dans une direction vers la surface de contact de coulissement de commande de gaz de l'unité de bague rotative (21) à partir des côtés d'extrémité longitudinaux de ladite une surface, et
l'élément de garniture arqué (42) est fixé dans la rainure annulaire en creux (27a) dans un état où l'arrière de la partie de l'élément de garniture arqué (42) où chaque surface inclinée de partie d'extrémité (42b) est formée et l'arrière de la partie de l'élément de garniture arqué (42) à côté de la surface inclinée de partie d'extrémité (42b) sont pressés par des moyens de sollicitation des éléments de fixation de garniture (43) vers la surface de contact de coulissement de commande de gaz de l'unité de bague rotative (21).

2. Rouleau scellé (56) qui comprend une partie de circulation de liquide de refroidissement (11) dans laquelle circule un liquide de refroidissement, une pluralité de canaux d'introduction de gaz (14) agencés sur toute une circonférence du rouleau scellé (56) à des intervalles sensiblement égaux dans une direction circonférentielle, et un joint rotatif (20) qui alimente un gaz de l'extérieur d'une chambre à vide (50) à chacun de la pluralité des canaux d'introduction de gaz (14), et qui refroidit un long substrat (52) transféré de rouleau à rouleau à travers la chambre à vide (50) en enveloppant le long substrat (52) sur une partie d'une surface périphérique extérieure du rouleau scellé (56), dans lequel
chacun de la pluralité de canaux d'introduction de gaz (14) comprend une pluralité de trous de décharge de gaz (15) s'ouvrant vers la surface périphérique extérieure à des intervalles sensiblement égaux le long d'une direction d'un axe de rotation du rouleau scellé (56),
le rouleau scellé (56) est commandé de telle sorte que le joint rotatif (20) alimente le gaz aux canaux d'introduction de gaz (14) situés dans une plage angulaire dans laquelle le long substrat (52) est enveloppé, et n'alimente pas un gaz aux canaux d'introduction de gaz (14) qui ne sont pas situés dans la plage angulaire dans laquelle le long substrat (52) est enveloppé,
**caractérisé en ce que**
le joint rotatif (20) comprend une unité de bague rotative (21) ayant une section transversale en forme de T et comprenant une pièce de base cylindrique (21a) et une pièce cylindrique saillante (21b) prévues coaxialement avec le rouleau scellé (56), et une unité de bague fixe (22) cylindrique dans laquelle la pièce cylindrique saillante (21b) de l'unité de bague rotative (21) est ajustée de sorte que la pièce cylindrique saillante (21b) et l'unité de bague fixe (22) comprennent chacune une surface de contact de coulissement de commande de gaz formée parallèlement à un axe central (56a) du rouleau scellé (56),
l'unité de bague rotative (21) comprend une pluralité de canaux d'alimentation en gaz (23) communiquant avec la pluralité de canaux d'introduction de gaz (14), respectivement, la pluralité de canaux d'alimentation en gaz (23) comprenant chacun une partie d'ouverture tournante (23a) sur la surface de contact de coulissement de commande de gaz de la pièce cylindrique saillante (21b) de l'unité de bague rotative (21), la partie d'ouverture tournante (23a) s'ouvrant à une position angulaire correspondant à une position angulaire, sur la surface périphérique extérieure du rouleau scellé (56), du canal d'introduction de gaz (14) communiquant avec le canal d'alimentation en gaz (23),
l'unité de bague fixe (22) comprend un canal de distribution de gaz (27) formé par une rainure annulaire en creux (27a), comprenant une partie fermée fixe et une partie d'ouverture fixe, et communiquant avec un tuyau d'alimentation (26) à l'extérieur de la chambre à vide (50), la rainure annulaire en creux (27a) étant prévue dans une surface circonférentielle intérieure cylindrique de l'unité de bague fixe (22), de manière à s'étendre dans la direction circonférentielle, la partie fermée fixe étant une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe étant une partie au niveau de laquelle la surface de contact de coulissement de commande de gaz n'est pas fermée, la partie d'ouverture fixe s'ouvrant dans une plage angulaire dans une région sur la surface de contact de coulissement de commande de gaz de l'unité de bague fixe (22) à laquelle font face les parties d'ouverture tournantes (23a) de la pièce cylindrique saillante (21b) de l'unité de bague rotative (21), la plage angulaire étant une plage dans laquelle le long substrat (52) est enveloppé,
l'élément de garniture arqué (42), qui est ajusté dans la région prédéterminée à l'intérieur de la rainure annulaire en creux (27a), comprend des surfaces inclinées de partie d'extrémité (42b) sur des côtés d'extrémité opposés d'une surface faisant face à la surface de contact de coulissement de commande de gaz de l'unité de bague rotative (21) de sorte que l'épaisseur de l'élément de garniture arqué (42) augmente progressivement dans une direction vers la surface de contact de coulissement de commande de gaz de l'unité de bague rotative (21) à partir des côtés d'extrémité longitudinaux de ladite une surface, et
l'élément de garniture arqué (42) est fixé dans la rainure annulaire en creux (27a) dans un état où l'arrière de la partie de l'élément de garniture arqué (42) où chaque surface inclinée de partie d'extrémité (42b) est formée et l'arrière de la partie de l'élément de garniture arqué (42) à côté de la surface inclinée de partie d'extrémité (42b) sont pressés par des moyens de sollicitation des éléments de fixation de garniture (43) vers la surface de contact de coulissement de commande de gaz de l'unité de bague rotative (21).

3. Rouleau scellé (56) selon la revendication 1 ou 2, dans lequel une dimension longitudinale des surfaces inclinées de partie d'extrémité (42b), qui sont formées sur des côtés d'extrémité longitudinaux opposés de l'élément de garniture arqué (42), est définie supérieure ou égale à un intervalle prédéterminé dans lequel les parties d'ouverture tournantes (23a) sont fournies à la surface de contact de coulissement de commande de gaz de l'unité de bague rotative (21).

4. Rouleau scellé (56) selon l'une des revendications 1 à 3, dans lequel
des côtés d'extrémité longitudinaux opposés de l'élément de garniture arqué (42) où sont formées les surfaces inclinées de partie d'extrémité (42b) sont fixés dans la rainure annulaire en creux (27a) en utilisant des moyens de fixation, et
une partie de l'élément de garniture arqué (42) autre que les côtés d'extrémité longitudinaux opposés est fixée de manière à être sollicitée vers la surface de contact de coulissement de commande de gaz de l'unité de bague rotative (21) en utilisant le moyens de sollicitation prévu sur le côté arrière de l'élément de garniture arqué (42).

5. Rouleau scellé (56) selon l'une des revendications 1 à 4, dans lequel l'élément de garniture arqué (42) est constitué d'une résine à base de fluor.

6. Appareil de traitement de long substrat comprenant :
une chambre à vide (50) ;
un mécanisme de transfert qui transfère de rouleau à rouleau un long substrat (52) à travers la chambre à vide (50) ;
un moyen de traitement (57, 58, 59, 60) pour effectuer un traitement qui applique une charge thermique au long substrat (52) ; et
un rouleau scellé (56) qui refroidit le long substrat (52) en enveloppant le long substrat sur une partie d'une surface périphérique extérieure du rouleau scellé (56) refroidie par la circulation d'un liquide de refroidissement,
**caractérisé en ce que**
le rouleau scellé (56) est le rouleau scellé (56) selon l'une des revendications 1 à 5.

7. Appareil de traitement de long substrat selon la revendication 6, dans lequel le traitement qui applique une charge thermique est un traitement au plasma ou un traitement par faisceau ionique.

8. Appareil de traitement de long substrat selon la revendication 7, dans lequel un mécanisme qui effectue le traitement au plasma ou le traitement par faisceau ionique fait face à un chemin de transfert défini sur la surface périphérique extérieure du rouleau scellé (56).

9. Appareil de traitement de long substrat selon la revendication 6, dans lequel le traitement qui applique une charge thermique est un traitement de dépôt sous vide.

10. Appareil de traitement de long substrat selon la revendication 9, dans lequel le traitement de dépôt sous vide est un traitement avec un moyen de dépôt sous vide faisant face à un chemin de transfert défini sur la surface périphérique extérieure du rouleau scellé (56).

11. Appareil de traitement de long substrat selon la revendication 10, dans lequel le moyen de dépôt sous vide est la pulvérisation magnétron.
